# EUROPEAN PATENT APPLICATION

(11) **EP 3 836 194 A1**
(43) Date of publication of application: **16.06.2021**
(21) Application number: 19215992.9
(22) Date of filing: 13.12.2019
(51) Int. Cl.: H01L 21/306, H01L 27/11556, H01L 27/11582

(54) **METAL ASSISTED CHEMICAL ETCH FOR CHANNEL AND BIT-LINE SCALING IN A 3D MEMORY DEVICE**

(71) Applicant: Imec VZW, 3001 Leuven (BE)
(72) Inventor: AJAYKUMAR, Arjun, 3001 Leuven (BE); VAN DEN BOSCH, Geert, 3001 Leuven (BE); ROSMEULEN, Maarten, 3001 Leuven (BE)
(74) Representative: Roth, Sebastian

(57) **Abstract**

The present invention disclosure relates to memory devices, in particular to three-dimensional (3D) memory devices. Embodiments of the invention provide a method for fabricating a 3D memory device, and a semiconductor structure for the 3D memory device. The embodiments of the method base on applying a metal assisted chemical etch (MACE) process to etch into a stack of the 3D memory device, in particular, to achieve channel scaling or channel and bit-line scaling. The method comprises forming a stack, which comprises a plurality of gate electrode layers and spacer layers, which are alternatingly arranged along a first direction. Further, the method comprises forming a semiconductor channel extending in the stack along the first direction, and etching into the semiconductor channel along the first direction using the MACE process, in order to form a trench.

## Description

### TECHNICAL FIELD

The present invention disclosure relates to memory devices, in particular to three-dimensional (3D) memory devices. Embodiments of the invention provide a method for fabricating a 3D memory device, and a semiconductor structure for the 3D memory device. The embodiments of the method base on applying a metal assisted chemical etch (MACE) process to etch into a stack of the 3D memory device, in particular, to achieve channel scaling or channel and bit-line scaling. The embodiments of the invention are especially useful for fabricating higher density, high aspect ratio 3D memory devices.

### BACKGROUND OF THE INVENTION

Conventionally, etching into a thick stack (or layer), for instance etching a narrow but deep trench during the fabrication of a 3D memory device, poses significant challenges. In particular, maintaining the high aspect ratio of the etched structure is difficult. The use of wet etch techniques is problematic for this case, due to its isotropic etch rate. Thus, dry etch techniques are typically used to etch narrow structures into thick stacks.

However, even by using a dry etch technique, the unwanted lateral etch - which increases with the thickness of the etched stack - cannot be fully rectified. Further, other etch non-uniformities, like tapering and twisting, occur frequently. These problems pose serious limitations for realizing high density, high aspect ratio structures in 3D memory devices.

### SUMMARY OF THE INVENTION

An objective of embodiments of the invention is therefore to provide a method able to fabricate higher density 3D memory devices. The method should enable a controlled channel scaling, or even channel and bit-line scaling, in order to increase the density of the fabricated 3D memory device. This kind of scaling requires trimming or splitting or cutting the channel, wherein the channel is formed having a high aspect ratio in a thick stack. In view of the above-discussed challenges that arise when etching high aspect ratio structures into thick stacks, embodiments of the present aim to provide a method employing an improved etch technique.

The objective is achieved by the embodiments of the invention provided in the enclosed independent claims. Advantageous implementations of these embodiments are defined in the dependent claims.

In particular, embodiments of the invention use the MACE process technology for etching a high aspect ratio trench into a thick stack, during fabrication of a 3D memory device.

The MACE process is an etch technique, which locally etches semiconductor materials, like germanium, silicon, or III-V semiconductor materials, in a wet chemistry containing an oxidant and an acidic solution. Further, metals, or other materials like graphene, act as a catalyst material for the etching. The etching happens in the semiconductor material, which is in contact with the catalyst material. The rate of the etching can be tuned by controlling the oxidant-to-acid ratio in the acidic solution. The MACE process is able to etch fast and with high uniformity.

A first aspect of the invention provides a method for fabricating a 3D memory device, the method comprising: forming a stack comprising a plurality of gate electrode layers and spacer layers, which are alternatingly arranged along a first direction; forming a semiconductor channel extending in the stack along the first direction; etching into the semiconductor channel along the first direction using a MACE process, in order to form a trench.

The method of the first aspect can trim or split the semiconductor channel, with a high etch uniformity, even in a thick stack, i.e. for a high aspect ratio of the final trench.

To "trim" the channel means scaling down the size of the channel, i.e., particularly to reduce its width. To "split" the channel means separating the channel into multiple separate parts, in particular two parts. Consequently, the method of the first aspect can lead to a higher density 3D memory device.

The semiconductor channel extending in the stack, may specifically extend through each gate electrode layer and spacer layer, respectively. The semiconductor channel may, however, also extend in the stack but adjacent to each gate electrode layer and spacer layer, respectively. In the first case, the gate electrode layers and spacer layers, respectively, may surround the channel, for instance, completely. This configuration is referred to as a gate-all-around (GAA) configuration. In the second case, the gate electrode layers and spacer layers may be arranged along and adjacent to the channel. For example, a flat-cell configuration may thus be realized. The channel, the gate electrode layers and the spacer layers may form a string of transistors. To this end, a dielectric material or ferroelectric material may further be provided between each gate electrode layer and the channel. That is, each gate electrode layer forms, together with the dielectric of ferroelectric material and the channel, at least one transistor. Each transistor may be associated with a memory cell of the 3D memory device. Accordingly, a string of transistors may be formed by the plurality of gate electrode layers. For instance, the string of transistor may form a NAND string of a 3D memory device of the NAND type.

In an implementation, the method further comprises: filling the trench, partially or completely, with at least one filler material.

This can provide better stability to the semiconductor structure and thus the 3D memory device. Further, electric properties, for instance of the memory cells, may thus be adjusted. The filling may be done by deposition or re-oxidation.

In an implementation of the method, the trench is formed only within the semiconductor channel.

Accordingly, only semiconductor material of the channel may be removed by etching the trench with the MACE process, thus trimming or splitting the channel.

In an implementation of the method, the semiconductor channel has, perpendicular to the first direction, a circular cross-section of a first diameter, and the trench has, perpendicular to the first direction, a circular cross-section of a second diameter that is smaller than the first diameter.

In this implementation, the channel is trimmed. In particular its thickness is reduced.

In an implementation of the method, the semiconductor channel is a full channel and is shaped into a macaroni channel by forming the trench.

A "full channel" may have the shape of cylinder or cuboid. In particular, the semiconductor material of a "full channel" does not surround/enclose any other material. In contrast, a "macaroni" channel may have the shape of a hollow cylinder or hollow cuboid. Accordingly, the "macaroni channel" may surround/enclose other material (e.g., dielectric or ferroelectric material) or air.

In an implementation of the method, the trench splits the channel into at least two disconnected parts, in particular into two disconnected halves.

In an implementation of the method, the trench extends along a second direction perpendicular to the first direction and thereby crosses the semiconductor channel.

That is, the trench may be elongated, perpendicular to the channel length. In the above implementations of the method, the channel is cut or split, i.e., may be separated into more than one part.

In an implementation of the method, the trench further splits an electrode layer connected to the channel into at least two disconnected parts.

By splitting the electrode layer, bit-line splitting, and thus bit-line scaling, can be additionally implemented. This allows obtaining a higher density 3D memory device.

In an implementation of the method, the trench has a particular shape, which splits the channel into at least three disconnected parts.

That is, a single, coherent trench may in this case split the channel into three or more disconnected parts. To this end, the trench may have a particular, complex shape. The MACE process may be performed by using a single piece of catalyst material (e.g., of metal or graphene), which has a suitable shape (e.g., has the same shape as the trench). The trench may in this case also split an electrode layer connected to the channel into at least three disconnected parts.

In an implementation of the method, at least two trenches are formed by etching into the semiconductor channel along the first direction using the MACE process; and the at least two trenches split the channel into at least three disconnected parts.

The MACE process maybe performed by using multiple pieces, e.g. multiple strips, of catalyst material (e.g., of metal or graphene). For instance, one strip of catalyst material may be used for each trench to be formed.

Each of the at least two channels may extend along a second direction perpendicular to the first direction and may thereby cross the semiconductor channel. The at least two trenches may further split an electrode layer connected to the channel into at least three disconnected parts. This implementations allows obtaining a higher density 3D memory device.

In an implementation of the method, the semiconductor channel has an elongated rectangular cross-section, with a length of the channel being perpendicular to the first direction; and the at least two trenches split the channel into at least three disconnected parts arranged along the length of the channel.

The at least three trenches may extend along the second direction, which may be perpendicular to the length of the channel.
In an implementation of the method, the semiconductor channel is a full channel or a macaroni channel.

In an implementation of the method, a first end of the channel is connected to a first electrode layer, which is arranged below the stack, and/or a second end of the channel is connected to a second electrode layer, which is arranged above the stack.

The "first end" and "second end" of the channel are thus with respect to its length. In particular, the channel has typically a high aspect ratio, i.e., is much deeper//longer than wide. At the front end and back end of the channel, respectively, one of the electrode layers may be provided.

The first and second electrode layer may function as source and drain contacts to the channel, and the gate electrode layers may function as control gates. The first and second electrode layers may be connected to a source-line and bit-line, of the 3D memory device, respectively.

In an implementation of the method, the semiconductor channel comprises silicon, germanium, and/or a III-V semiconductor material.

In an implementation of the method, the at least one filler material comprises a dielectric material and/or an oxide.

In an implementation of the method, the gate electrode layers and spacer layers are alternatingly grown on top of each other; and the semiconductor channel is a vertical channel extending perpendicular to the surface of each gate electrode layer and spacer layer.

Thereby, the channel may either pass through each individual gate electrode layer and spacer layer, respectively, or the channel may pass by (adjacent) each individual gate electrode layer and spacer layer.

In an implementation of the method, the MACE process is performed using a metal and/or graphene as a catalyst material, and the method further comprises removing the catalyst material from the bottom of the trench.

A second aspect of the invention provides a semiconductor structure for a 3D memory device, wherein the semiconductor structure is fabricated by a method according to the first aspect or any implementation form thereof.

The semiconductor structure of the second aspect achieves the same advantages as the method of the first aspect or its implementation forms.

In particular, the semiconductor structure of the second aspect may comprise a trimmed or split channel. The trimmed channel may have a particular high uniformity, which clearly distinguishes it from channels made by other etch techniques.

### BRIEF DESCRIPTION OF THE DRAWINGS

The above described aspects and implementations are explained in the following description of embodiments with respect to the enclosed drawings:
- FIG. 1: shows a method according to a general embodiment of the invention.
- FIG. 2: shows a method according to a specific embodiment of the invention, to trim a channel.
- FIG. 3: shows a method according to a specific embodiment of the invention, to split a full channel.
- FIG. 4: shows method according to a specific embodiment of the invention, to split a macaroni channel.

### DETAILED DESCRIPTION OF EMBODIMENTS OF THE INVENTION

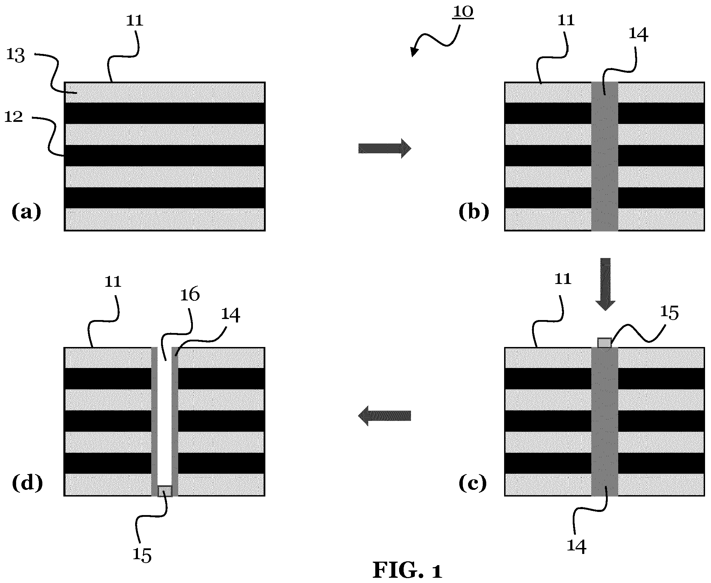

FIG. 1 shows a method 10 according to a general embodiment of the invention. The method 10 is for fabricating a 3D memory device, i.e. it maybe used in a fabrication process flow of the 3D memory device. In particular, the method 10 may implement etching high aspect ratio structures during the fabrication of the 3D memory device. The specific application of the method 10 maybe trimming and/or splitting a narrow semiconductor channel formed in a thick stack needed for such a 3D memory device. The 3D memory device may be of the NAND-type, and the channel may be the channel of a NAND string.

The method 10 comprises (see FIG. 1(a)) forming a stack 11, which comprises a plurality of gate electrode layers 12 and spacer layers 13, respectively. The gate electrode layers 12 and spacer layers 13 are alternatingly arranged, along a first direction, i.e., they are alternatingly arranged one on the other. The first direction may correspond to the direction of forming (e.g. depositing or growing) the gate electrode layers 12 and spacer layers 13, respectively. In particular, the first direction may be the vertical direction as in FIG. 1. Thus, the gate electrode layers 12 and spacer layers 13 may be alternatingly arranged one above the other.

The plurality of gate electrode layers 12 may, but do not have to, be identical. The plurality of spacer layers 13 may, but do not have to, be identical. The stack 11 may include (much) more gate electrode layers 12 and spacer layers 13 than are shown in FIG. 1, thus the stack 11 may be much thicker. Further, it is only exemplary, that a spacer layer 13 is shown in FIG. 1 as both the top-most layer and the bottom-most layer of the stack 11.

The gate electrode layers 12 may each comprise at least one of the following materials: Cu, Al, Ti, W, Ni, Au, TiN, TaN, TaC, NbN, RuTa, Co, Ta, Mo, Pd, Pt, Ru, Ir, and Ag. The spacer layers 13 may each comprise at least one of the following materials: SiO2, SiO, SiN, SiON, Al2O3, AlN, MgO, and carbides. Notably, the gate electrode layers 12 may also be formed by first forming sacrificial layers (e.g., comprising Si₃N₄ layers) and later replacing the sacrificial layers by layers comprising the above-mentioned materials.

Further, the method comprises (see FIG. 1(b)), forming a semiconductor channel 14, which extends in the stack 11 along the first direction. Here, in FIG. 1, the semiconductor channel 14 extends exemplarily through the stack 11, i.e. through each of the gate electrode layers 12 and spacer layers 13, respectively. Accordingly, the channel 14 passes sequentially all of the gate electrode layers 12 and spacer layers 13. The semiconductor channel 14 may have a circular diameter. Further, the channel 14 may be surrounded by each of the gate electrode layers 12 and spacer layers 13, respectively. The gate electrode layers 12 and spacer layers 13 may particularly surround the channel 14 completely (e.g., they may each have a full-circle shape). The semiconductor channel 14 may comprise at least one of the following materials: Si, SiGe, Ge, GaAs, GaAsP, InAs, InSb, and InP. Notably, the forming of the gate electrode layers 12, the spacer layers 13 and the channel 14, respectively, does not have to follow a determined order. For instance, with reference to above, the gate electrode layers 12 may be formed by first forming the sacrificial layers, which maybe replaced after the channel 14 is formed.

Further, the method 10 comprises etching into the semiconductor channel 14, along the first direction, using a MACE process. The MACE process is performed by using a metal and/or graphene and/or other suitable catalyst material 15. This catalyst material 15 maybe deposited on the top surface of the stack 11, particularly on the upper end of the channel 14 (see FIG. 1(c)). The MACE process may then form at least one trench 16 (see FIG. 1(d)) into the stack 11. This trench 16 may be formed only within the semiconductor channel 14, i.e., only the semiconductor material of the channel 14 is etched. During the forming of the trench 16, the catalyst material 15 is typically always at the current bottom of the trench 16. The method 10 may further comprise removing the catalyst material 15 from the bottom of the final trench 16. Depending on the size and/or on the shape of the trench 16, the channel 14 can be trimmed and/or split by etching the trench 16, as is explained further below.

The method 10 finally fabricates a semiconductor structure for use in (fabricating) a 3D memory device. This semiconductor structure, according to an embodiment of the invention, comprises the stack 11 (including the gate electrode layers 12 and spacer layers 13) and comprises the channel 14 (e.g., a trimmed and/or split full channel), which extends in the stack 11 through and/or along the gate electrode layers 12 and spacer layers 13. The semiconductor structure may be further processed to obtain the 3D memory device.

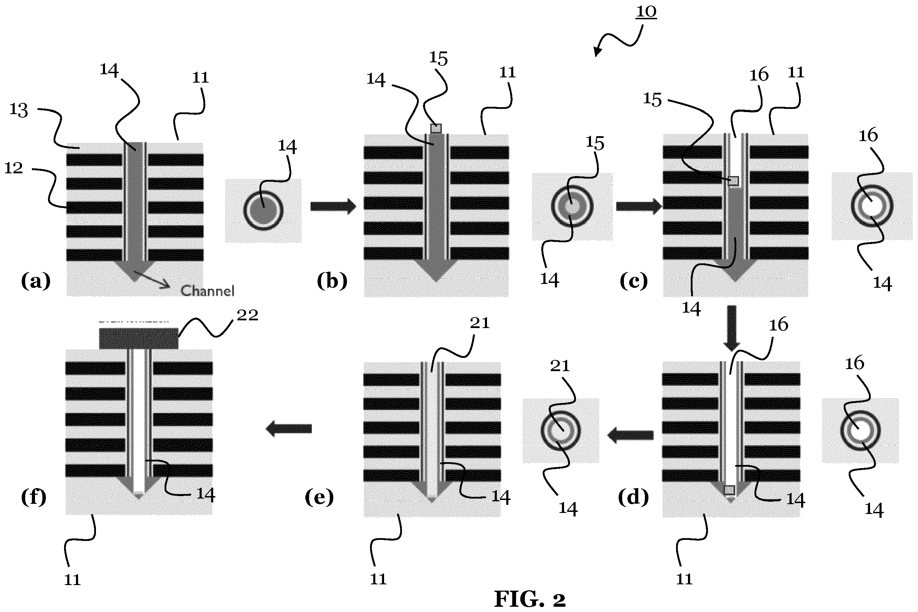

FIG. 2 shows the method 10 according to a specific embodiment of the invention, which builds on the embodiment show in FIG. 1. Same elements in FIG. 1 and FIG. 2 are labelled with the same reference signs. In particular, FIG. 2 shows how the method 10 can be used to trim the channel 14, which is formed in the stack 11 comprising the alternatingly arranged gate electrode layers 12 and spacer layers 13 (see FIG. 2(a)). The subsequently obtained intermediate structures, resulting from the individual method steps, are shown in a cross-section. Additionally, a top view showing schematically the surface region around the upper end of the channel 14 is provided for each intermediate structure.

In this embodiment, the MACE process is particularly used to trim down the channel 14, i.e. reduce its thickness. For example, a full channel is formed into a macaroni channel. That is, the semiconductor channel 14 is initially a full channel, and is shaped into the macaroni channel by forming the trench 16 with the MACE process. Macaroni channels are often employed in 3D memory devices like flash.

The catalyst material 15 (e.g., metal or graphene) is deposited on top on the stack 11, particularly on the channel 14, partially covering the channel (see FIG. 2(b)). The channel 14 has in this embodiment a circular diameter (in cross-section), and the catalyst material 15 may be smaller and arranged within that circular diameter.

Then the MACE process is performed, whereby the trench 16 is created. The trench 16 is at first created partially (see FIG. 2(c)), and is then at some point fully established (see FIG. 2(d)) in the stack 11. For instance, the fully established channel 14 passes through all the gate electrode layers 12 and spacer layers 13. In this embodiment, the semiconductor channel 14 has, perpendicular to the first direction, a circular cross-section of a first diameter, and the trench 16 has, perpendicular to the first direction, a circular cross-section of a second diameter that is smaller than the first diameter. Thus, the trench 16 is formed only within the semiconductor channel 14.

After the MACE process is completed, the catalyst 15 is located at the bottom of the fully established trench 16, i.e., is located at the bottom of the stack 11, and stays there at first. The MACE process can ensure a much more uniform profile of the trimmed channel 14, particularly for thick stacks 11. By using the MACE process, the thickness of the channel 14 (full channel in FIG. 2(a)) is trimmed to a reduced thickness channel 14 (see FIG. 2(d)). Notably, conventional chemical vapor deposition (CVD) processes, or the like, cannot be employed to deposit narrow channels in thick stacks (high aspect ratio), due to discontinuous film towards the stack bottom.

The MACE process may be followed by removal of the catalyst material 15, e.g., by a wet process. Further, the method 10 may comprise filling the trench 16, partially or completely, with at least one filler material 21 (see FIG. 2(e)). The filler material 21 may be deposited into the trench 16. The filler material 21 may comprise a dielectric material and/or an oxide, e.g. a silicon or other semiconductor material oxide.

The method 10 may further comprise formation of an electrode layer 22 (see FIG. 2(f)), in particular, formation of a drain electrode layer 22. Generally, the method 10 may comprise forming a first electrode layer, which is arranged below the stack 11 (not shown), and connecting to the channel 14 as a source contact, and forming the electrode layer 22, which is arranged above the stack 11, and connecting to the channel 14 as a drain contact.

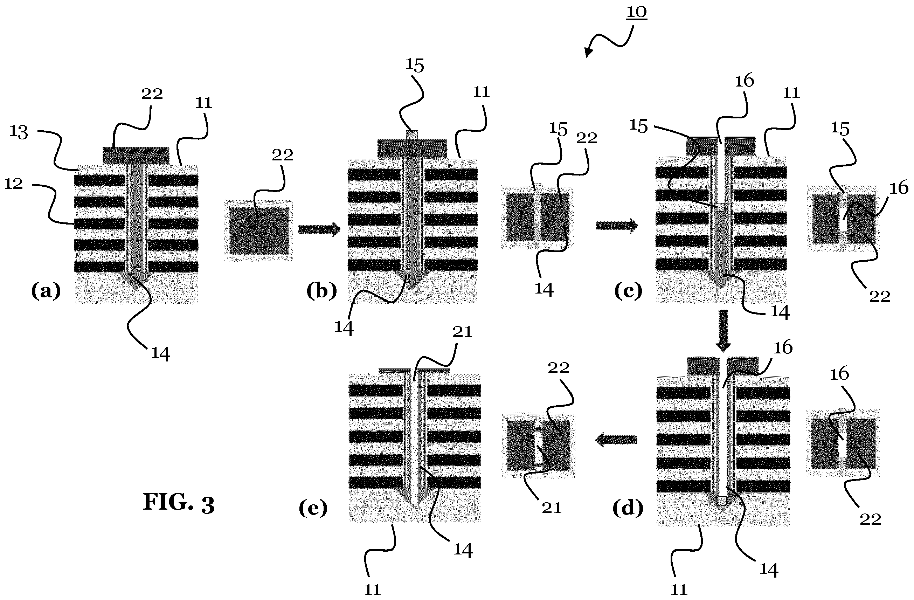

FIG. 3 shows the method 10 according to another specific embodiment of the invention, which builds on the embodiment show in FIG. 1. Same elements in FIG. 1 and FIG. 3 are labelled with the same reference signs. In particular, FIG. 3 shows how the method 10 can be used to split a full channel 14, which is formed in the stack 11 comprising the alternatingly arranged gate electrode layers 12 and spacer layers 13 (see FIG. 3(a). The subsequently obtained intermediate structures, resulting from the individual method steps, are shown in a cross-section. Additionally, a top view showing schematically the surface region around the upper end of the channel 14 is provided for each intermediate structure.

In particular, in this the embodiment, the MACE process may be used for channel scaling, or channel scaling and bit-line scaling. Bit-line scaling is valuable to meet the requirements of next generation 3D memory devices in terms of bit density.

A shown in FIG. 3(a), an electrode layer 22 (e.g., a drain electrode layer) is formed on top of the stack 11, in particular covering the upper end of the channel 14. Then, a stripe of catalyst material 15 (e.g., a metal or graphene stripe) is deposited on top of the structure, i.e., on top of the electrode layer 22 (see FIG. 3(b)). The stripe may cross the circular diameter, which the channel 14 has in this embodiment.

During an initial step of the subsequent MACE process, the electrode layer 22 is split by the etching, and the catalyst material 15 thereby approaches the electrode-to-channel interface. In particular the trench 16 thus splits the electrode layer 22, which is connected to the channel 14, into two disconnected parts.

In the remaining MACE process step, etching occurs only where the catalyst material 15 is in contact with the semiconductor channel 14, while no etching occurs where the catalyst material 15 is in contact with the top spacer layer 13 (e.g., a dielectric (oxide)). Thus, the top spacer layer 13 remains intact (see FIG. 3(d)). Further, the trench 16 splits the channel 16 into two disconnected parts, in particular into two disconnected halves. Thereby, the trench 16 may extend, as shown, along a second direction perpendicular to the first direction, and thereby cross the semiconductor channel 14 (in the top view).

After the trench 16 is fully established in the channel 14, a removal of the catalyst material 15 may follow, e.g., by a wet process. Further, the trench 16 may be filled partially or completely, with a filler material 21 (e.g., by performing oxide deposition), in order to form the resulting semiconductor structure shown in FIG. 3(e).

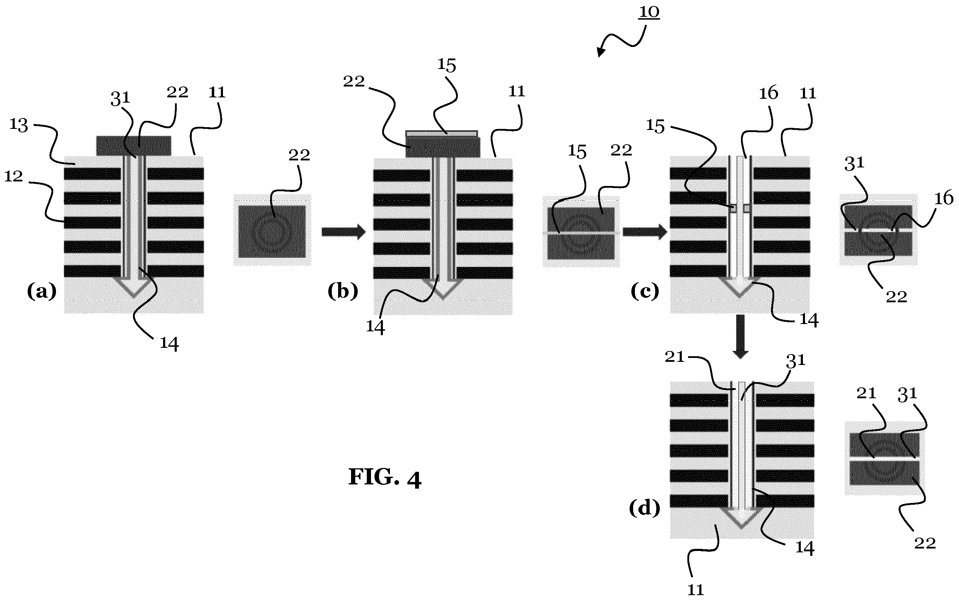

FIG. 4 shows the method 10 according to another specific embodiment of the invention, which builds on the embodiment show in FIG. 1. Same elements in FIG. 1 and FIG. 4 are labelled with the same reference signs. In particular, FIG. 4 shows how the method 10 can be used to split a macaroni channel 14, which is formed in the stack 11 comprising the alternatingly arranged gate electrode layers 12 and spacer layers 13 (see FIG. 4(a). The macaroni channel 14 has the shape of a hollow cylinder, and is filled with a filling material 31 (could be the same as the filler material 21 described above). The subsequently obtained intermediate structures, resulting from the individual method steps, are shown in a cross-section. Additionally, a top view showing schematically the surface region around the upper end of the channel 14 is provided for each intermediate structure.

In particular, in this the embodiment the MACE process may be used for channel scaling, or channel scaling and bit-line scaling, for macaroni device, i.e., in the case that the channel 14 is not a full channel (as in FIG. 3) but a macaroni channel.

As shown in FIG. 4(a), an electrode layer 22 (e.g., a drain electrode layer) is formed on top of the stack 11, in particular over the upper end of the channel 14. Then, a stripe (see FIG. 4(b)) of a catalyst material 15 (e.g., a metal or graphene stripe) is deposited on top of the intermediated structure, i.e. on top of the electrode layer 22.

During an initial step of the subsequent MACE process, the electrode layer 22 is split by the etching, and the catalyst material 15 thereby approaches the electrode-to-channel interface. In particular the trench 16 thus splits the electrode layer 22, which is connected to the channel 14, into two disconnected parts.

In the remaining MACE process step, etching occurs only where the catalyst material 15 is in contact with the semiconductor channel 14, i.e., the semiconductor material of the macaroni channel 14. No etching occurs where the catalyst material 15 is in contact with the top spacer layer 13 (e.g., a dielectric (oxide)) or with the filling material 31 inside the macaroni channel 14. Thus, the top spacer layer 11 remains intact, like the filling material 31 (see FIG. 3(d)). Further, the trench 16 splits the channel 14 into two disconnected parts, in particular into two disconnected halves. Thereby, the trench 16 may extend, as shown, along a second direction perpendicular to the first direction, and thereby cross the semiconductor channel 14 (in the top view).

After the trench 16 is fully established in the channel 14, a removal of the catalyst material 15 may follow, e.g., by a wet process. Further, the trench 16 may be filled partially or completely, with a filler material 21 (e.g., by performing oxide deposition), in order to form the resulting semiconductor structure shown in FIG. 3(e).

In an embodiment of the invention, multiple trenches 16 may be formed. As an example, forming the multiple trenches 16 may start from FIG. 3(a) or FIG. 4(a), i.e. from a full channel 14 or macaroni channel 14 formed in the stack 11. Instead of having a circular cross-section, as is exemplarily illustrated in FIG. 3 and FIG. 4, respectively, the channel 14 may have an elongated rectangular cross-section. The channel 14 may have a length L perpendicular to the first direction. Thereby, the length L maybe larger (L > >W) than a width W of the channel 14. For instance, the width W of the channel 14 may be around 100nm. The length L of the channel 14 maybe in a range of 1 to several µm, e.g., in a range of 1-10µm.

The semiconductor material of the channel 14 (e.g., poly silicon) may be cut/split into multiple disconnected parts by forming the multiple trenches 16. For instance, two or more trenches 16 may be formed to split the channel 14 into three or more disconnected parts. This may be done in a similar fashion as shown in FIG. 3 or FIG. 4. The splitting, i.e., the MACE process, could be done by using multiple pieces of catalyst material 15 (e.g., multiple metal or graphene strips), which may be applied to the top of the structure, i.e., the channel 14 top and/or the top of the electrode layer 22. Alternatively, the MACE process could be done by using a single piece of catalyst material (e.g. a metal or graphene piece) having a suitable shape. In the latter case, it may be better to start from a full channel rather than a macaroni channel. The MACE process may also split the electrode layer 22 into two or more disconnected parts.

In summary, the embodiments of the invention provide a method 10 that allows etching into a thick stack 11 without the disadvantages provided by conventional wet or dry etching, particularly the lateral etch. The method 10 etches specifically a pre-formed channel 14, i.e., etches the trench 16 into the channel. In this way, the channel 14 can be trimmed or split, in order to produce a higher density 3D memory device in the further processing.

## Claims

1. A method (10) for fabricating a 3D memory device, the method (10) comprising:
forming a stack (11) comprising a plurality of gate electrode layers (12) and spacer layers (13), which are alternatingly arranged along a first direction;
forming a semiconductor channel (14) extending in the stack (11) along the first direction;
etching into the semiconductor channel (14) along the first direction using a Metal (15) Assisted Chemical Etch, MACE, process, in order to form a trench (16).

2. The method (10) according to claim 1, further comprising:
filling the trench (16), partially or completely, with at least one filler material (21).

3. The method (10) according to claim 1 or 2, wherein:
the trench (16) is formed only within the semiconductor channel (14).

4. The method (10) according to one of the claims 1 to 3, wherein:
the semiconductor channel (14) has, perpendicular to the first direction, a circular cross-section of a first diameter, and
the trench (16) has, perpendicular to the first direction, a circular cross-section of a second diameter that is smaller than the first diameter.

5. The method (10) according to claim 3 or 4, wherein:
the semiconductor channel (14) is a full channel and is shaped into a macaroni channel by forming the trench (16).

6. The method (10) according to one of the claims 1 to 3, wherein:
the trench (16) splits the channel (14) into at least two disconnected parts, in particular into two disconnected halves.

7. The method according to claim 6, wherein:
the trench (16) extends along a second direction perpendicular to the first direction and thereby crosses the semiconductor channel (14).

8. The method (10) according to claim 6 or 7, wherein:
the trench further splits an electrode layer (22) connected to the channel (14) into at least two disconnected parts.

9. The method (10) according to one of the claims 6 to 8, wherein:
the trench (16) has a particular shape, which splits the channel (14) into at least three disconnected parts.

10. The method (10) according to one of the claims 1 to 3, wherein:
at least two trenches (16) are formed by etching into the semiconductor channel (14) along the first direction using the MACE process; and
the at least two trenches (16) split the channel (14) into at least three disconnected parts.

11. The method (10) according to claim 10, wherein:
the semiconductor channel (14) has an elongated rectangular cross-section, with a length of the channel (14) being perpendicular to the first direction; and
the at least two trenches (16) split the channel (14) into at least three disconnected parts arranged along the length of the channel (14).

12. The method (10) according to one of the claims 6 to 11, wherein:
the semiconductor channel (14) is a full channel or a macaroni channel.

13. The method (10) according to one of the claims 1 to 12, wherein:
a first end of the channel (14) is connected to a first electrode layer, which is arranged below the stack (11), and/or
a second end of the channel (14) is connected to a second electrode layer (22), which is arranged above the stack (11).

14. The method (10) according to one of the claims 1 to 13, wherein:
the semiconductor channel (14) comprises silicon, germanium, and/or a III-V semiconductor material.

15. The method (10) according to one of the claims 1 to 14 when depending on claim 2, wherein:
the at least one filler material (21) comprises a dielectric material and/or an oxide.

16. The method (10) according to one of the claims 1 to 15, wherein:
the gate electrode layers (12) and spacer layers (13) are alternatingly grown on top of each other; and
the semiconductor channel (14) is a vertical channel extending perpendicular to the surface of each gate electrode layer (12) and spacer layer (13).

17. The method (10) according to one of the claims 1 to 16, wherein:
the MACE process is performed using a metal and/or graphene as a catalyst material (15), and
the method (10) further comprises removing the catalyst material (15) from the bottom of the trench (16).

18. A semiconductor structure for a 3D memory device, wherein the semiconductor structure is fabricated by a method (10) according to any one of the claims 1017.
